(19) Europäisches Patentamt
European Patent Office
Office européen des brevets

(11) **EP 4 311 106 A1**

(12) **EUROPEAN PATENT APPLICATION**
published in accordance with Art. 153(4) EPC

(43) Date of publication:
**24.01.2024 Bulletin 2024/04**

(21) Application number: **21936811.5**

(22) Date of filing: **03.12.2021**

(51) International Patent Classification (IPC):
**H03F 1/02** (2006.01)

(52) Cooperative Patent Classification (CPC):
**H03F 1/02; H03F 1/56; H03F 3/195; H03F 3/213;
H04B 1/04;** Y02D 30/70

(86) International application number:
**PCT/CN2021/135499**

(87) International publication number:
**WO 2022/217945 (20.10.2022 Gazette 2022/42)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **12.04.2021 CN 202110389641**

(71) Applicant: **Huawei Technologies Co., Ltd.
Longgang
Shenzhen, Guangdong 518129 (CN)**

(72) Inventor: **REN, Zhixiong
Shenzhen, Guangdong 518129 (CN)**

(74) Representative: **Maiwald GmbH
Engineering
Elisenhof
Elisenstrasse 3
80335 München (DE)**

(54) **DIGITAL POWER AMPLIFIER AND COMMUNICATION SYSTEM**

(57) This application provides a digital power amplifier and a communication system. The digital power amplifier includes a decoder and N transistor sets. The decoder includes an input end and N groups of output ends, the input end of the decoder is connected to a baseband processing unit, the N groups of output ends of the decoder are respectively connected to the N transistor sets, and the N transistor sets operate within at least two different operating voltage ranges. The decoder is configured to receive K quantization levels corresponding to a to-be-amplified signal from the baseband processing unit, and send a target quantization level in a same operating voltage range of the K quantization levels to a transistor set that operates in the operating voltage range. The N transistor sets are configured to respectively amplify target quantization levels received by the N transistor sets.

FIG. 6

**Description**

This application claims priority to Chinese Patent Application No. 202110389641.0, filed with the China National Intellectual Property Administration on April 12, 2021 and entitled "DIGITAL POWER AMPLIFIER AND COMMUNICATION SYSTEM", which is incorporated herein by reference in its entirety.

**TECHNICAL FIELD**

This application relates to the field of communication technologies, and in particular, to a digital power amplifier and a communication system.

**BACKGROUND**

To improve spectrum utilization efficiency, modulation signals of different standards are used in wireless communication, for example, orthogonal frequency division multiplexing (orthogonal frequency division multiplexing, OFMA), code-division multiple access (code-division multiple access, CDMA), and time division multiple access (time division multiple access, TDMA). According to related protocols, signals of these standards have different peak-to-average ratios (peak-to-average power ratio, PAPR). For example, a peak-to-average ratio of an orthogonal frequency division multiplexing (orthogonal frequency division multiplexing, OFDM) signal is 10 dB to 12 dB.

To ensure lossless transmission of a radio frequency signal, a power amplifier (power amplifier, PA) is required to have a high linearity feature. A signal with a high peak-to-average power ratio has a higher requirement on the power amplifier in a base station. Based on a feature of a power tube, an amplifier has a linear dynamic range. Within this range, output power of the amplifier increases linearly with input power. As the input power continues to increase, the amplifier gradually enters a saturation region, and a power gain starts to decrease. To ensure linearity of the PA, a power back-off method may be used, so that the PA backs off to a linear operation region. However, there is a compromise relationship between linearity and efficiency of the PA, and the efficiency is sacrificed while the linearity is ensured, thereby increasing power consumption of the PA. When the power amplifier needs to meet a high peak-to-average power ratio requirement, for example, when the peak-to-average power ratio is 10 dB to 12 dB, the PA needs to work in a corresponding 10 dB to 12 dB backoff region. In this case, the efficiency of the power amplifier is very low (even lower than 4%), that is, under same output power, the low efficiency causes the input power of the base station to be greatly increased. As one of core modules of a transmitter system, the power amplifier consumes more than 30% of total power consumption of the system. Therefore, when the linearity and the peak-to-average power ratio of signal amplification are met, power consumption of the power amplifier needs to be reduced urgently.

A digital PA (digital PA, DPA) uses, with reference to a high efficiency feature of a switching PA, a plurality of bits to quantize an input analog signal, to obtain a digital signal of a corresponding quantity of bits, and then inputs the digital signal to the DPA for power amplification, thereby effectively improving the linearity of the DPA. To improve precision of the DPA to meet a requirement of system linearity, a quantity of transistors in the DPA and a quantity of quantization bits of a signal increase exponentially. For example, to obtain 15-bit DPA quantization precision, the quantity of transistors reaches thousands, resulting in relatively high costs and complexity of the power amplifier.

**SUMMARY**

This application provides a digital power amplifier and a communication system, to reduce a quantity of transistors in the digital power amplifier while ensuring quantization precision of the digital power amplifier by designing the transistors in the digital power amplifier, thereby reducing overheads of the power amplifier and improving overall performance of the power amplifier.

According to a first aspect, this application provides a digital power amplifier DPA, including a decoder and N transistor sets. The decoder includes an input end and N groups of output ends, the input end of the decoder is connected to a baseband processing unit, the N groups of output ends of the decoder are respectively connected to the N transistor sets, and the N transistor sets operate within at least two different operating voltage ranges. The decoder is configured to receive K quantization levels corresponding to a to-be-amplified signal from the baseband processing unit, and send a target quantization level within a same operating voltage range of the K quantization levels to a transistor set that operates in the operating voltage range. N is a positive integer greater than 1, and K is a positive integer. The N transistor sets are configured to respectively amplify target quantization levels received by the N transistor sets.

In the foregoing implementation, the N transistor sets operate within at least two different operating voltage ranges, so that each transistor set amplifies a corresponding quantization level at most within the operating voltage range of the transistor set. Therefore, a quantity of amplified quantization bits corresponding to each transistor set is at most a quantity of quantization levels corresponding to the transistor set within the operating voltage range, which is far less than that in the current technology, a quantity of transistors in the DPA that are in an exponential relationship with a quantity of quantization bits when all transistors in the DPA operate at a same operating voltage. Therefore, under the same quantization precision, a quantity of transistors that need to be disposed in the DPA may be significantly reduced, costs and complexity of the power amplifier are also reduced, and the overheads of the power amplifier in the communication system are also reduced.

In a possible implementation, at least two transistor sets in the N transistor sets operate within a first operating voltage range, the first operating voltage range includes at least two voltage sub-ranges in which voltage values do not overlap, and the at least two voltage sub-ranges are in a one-to-one correspondence with the at least two transistor sets. The decoder is configured to send a target quantization level within a same voltage sub-range in the K quantization levels to a transistor set corresponding to the voltage sub-range. The transistor set corresponding to the voltage sub-range is configured to amplify a received quantization level within the voltage sub-range.

In the foregoing implementation, the transistor set may correspondingly amplify a quantization level in a non-overlapping voltage sub-range separately. Therefore, a quantization bit corresponding to the transistor set may be corresponding to a quantization bit of the quantization level within the voltage sub-range.

For example, in a scenario in which the to-be-amplified signals are all formed based on non-overlapping voltage sub-ranges, a sum of quantities of quantization bits corresponding to the transistor sets is a quantity of quantization bits of the to-be-amplified signals. Therefore, a quantity of transistors in the transistor set may be reduced.

In a possible implementation, two transistor sets in the N transistor sets correspond to a same operating voltage range, and the two transistor sets correspond to different quantities of quantization bits. The decoder is further configured to: determine, from the K quantization levels, a target quantization level within the operating voltage range corresponding to the two transistor sets; select, from the two transistor sets, a target transistor set whose quantity of quantization bits is the same as a quantity of quantization bits corresponding to the target quantization level; and send the target quantization level corresponding to the operating voltage range to the target transistor set.

In the foregoing implementation, the transistor set may include two transistor sets within a same operating voltage range, so that when quantities of quantization bits of the to-be-amplified signal are different, the decoder may select, based on a plurality of transistor sets corresponding to the target quantization level within the operating voltage range, a target transistor set that matches the target quantization level, so that when the digital power amplifier amplifies signals of different quantities of quantization bits, amplification may be more flexibly performed, to better reduce power consumption overheads of the DPA and improve amplification performance of the DPA.

In a possible implementation, for any operating voltage range in the N operating voltage ranges, a magnitude of the operating voltage range or a quantity of quantization bits corresponding to a transistor set that operates within the operating voltage range is related to a probability that a voltage value of an envelope signal of an analog signal of the to-be-amplified signal appears within the operating voltage range; or a magnitude of the operating voltage range or a quantity of quantization bits of a transistor set that operates within the operating voltage range is related to a probability that power spectral density of an envelope signal of an analog signal of the to-be-amplified signal appears within the operating voltage range.

In the foregoing implementation, it is considered that the probability that the envelope signal of the to-be-amplified signal appears at different voltage values is different may correspond to the magnitude of the operating voltage range of the transistor set. It is considered that a larger operating voltage range indicates a larger quantity of transistors in the transistor set under the same quantization precision, a larger probability that the envelope signal of the to-be-amplified signal appears at different voltage values indicates a smaller operating voltage range, so as to reduce a quantity of disposed transistors. For another example, a smaller probability that the envelope signal based on the to-be-amplified signal appears at different voltage values indicates a larger operating voltage range obtained through division, so as to reduce a quantity of transistor sets, and correspondingly, reduce a quantity of transistors.

In addition, it is considered that a probability that the envelope signal of the to-be-amplified signal appears at different voltage values is different, it is reflected that the power spectral density of the envelope signal of the to-be-amplified signal is also different. For example, larger power spectral density of the envelope signal of the to-be-amplified signal indicates higher quantization precision required at the position. Therefore, correspondingly, a smaller operating voltage range of the transistor set ensures quantization precision of the DPA and reduces the quantity of transistors in the DPA.

In a possible implementation, the transistor set includes at least one transistor, and the at least one transistor uses a same operating voltage. In the foregoing implementation, the transistor set may share a power supply, which simplifies complexity of the DPA.

In a possible implementation, each of the N transistor sets corresponds to one or more of K quantization bits. The decoder is configured to determine a target quantization bit of the target quantization level in the K quantization bits, and send the target quantization level to a transistor set corresponding to the target quantization bit.

In the foregoing implementation, the decoder sends the target quantization level to each transistor set based on that each transistor set may correspondingly amplify one or more of the K quantization levels, to implement amplification of the K quantization levels and simplify complexity of the transistor set.

In a possible implementation, the transistor set further includes: a first switched capacitor, where the first switched capacitor is connected to all transistors in the transistor set; or each second switched capacitor connected to each transistor in the transistor set. The first switched capacitor or each second switched capacitor is configured to receive a quantization level corresponding to the transistor set, and transmit the quantization level to a connected transistor. The transistor is configured to amplify the quantization level sent by the switched capacitor.

In the foregoing implementation, different transistor sets are isolated from each other through the first switched capacitor or the second switched capacitor, to reduce interference between the different transistor sets or the different transistors, and improve performance of the power amplifier.

In a possible implementation, the DPA includes a first power amplification unit, a second power amplification unit, and a combination unit. The first power amplification unit is a primary power amplifier, and the second power amplification unit is a secondary power amplifier, or the first power amplification unit is a secondary power amplifier, and the second power amplification unit is a primary power amplifier. The N transistor sets are located in the first power amplification unit and/or the second power amplification unit. The first power amplification unit is configured to amplify a first sub-signal of the to-be-amplified signal to obtain a first amplified sub-signal, and send the first amplified sub-signal to the combination unit. The second power amplification unit is configured to amplify a second sub-signal of the to-be-amplified signal to obtain a second amplified sub-signal, and send the second amplified sub-signal to the combination unit. The combination unit is configured to combine the first amplified sub-signal and the second amplified sub-signal to obtain a target amplified signal corresponding to the to-be-amplified signal.

In the foregoing implementation, power back-off performance of the power amplifier is improved with reference to a Doherty architecture, and overall performance of the digital power amplifier is improved while a quantity of transistors in the power amplifier is reduced.

In a possible implementation, the DPA further includes an impedance matching network, and the impedance matching network is configured to match impedance of the N transistor sets.

In the foregoing implementation, when the N transistor sets in the DPA amplify K quantization levels, and operate in an impedance matching state, power consumption of the N transistor sets is reduced and efficiency of the DPA is improved.

According to a second aspect, this application provides a communication system, including a baseband processing unit; at least one DPA according to any one of the first aspect that is connected to the baseband processing unit; and an antenna connected to the at least one DPA.

BRIEF DESCRIPTION OF DRAWINGS

FIG. 1 is a schematic diagram of a structure of a power amplifier according to an embodiment of this application;
FIG. 2 is a schematic diagram of a structure of a communication system;
FIG. 3 is a schematic diagram of a polar architecture of a communication system;
FIG. 4 is a schematic diagram of an architecture of an inphase-quadrature signal (inphase-quadrature, IQ) of a communication system;
FIG. 5 is a schematic diagram of a structure of a digital power amplifier;
FIG. 6 is a diagram of a structure of a communication system according to an embodiment of this application;
FIG. 7a and FIG. 7b are schematic diagrams of a time envelope signal;
FIG. 8 is a schematic diagram of a synthesized signal according to an embodiment of this application;
FIG. 9 is a schematic diagram of a power spectral density corresponding to a time envelope signal;
FIG. 10a to FIG. 10c are schematic diagrams of a relationship between a transistor set and a voltage range according to an embodiment of this application;
FIG. 11 is a diagram of a structure of a transistor according to an embodiment of this application;
FIG. 12 is a diagram of a structure of a communication system according to an embodiment of this application;
FIG. 13 is a diagram of a structure of a digital power amplifier according to an embodiment of this application;
FIG. 14 is a schematic diagram of an efficiency curve of a digital power amplifier according to an embodiment of this application;
FIG. 15 is a schematic diagram of a structure of a Doherty power amplifier according to an embodiment of this application;
FIG. 16 is a schematic diagram of a working efficiency curve of a power amplifier; and
FIG. 17 is a schematic diagram of a structure of a radio frequency system according to an embodiment of this application.

**DESCRIPTION OF EMBODIMENTS**

Technical solutions in embodiments of this application may be applied to various communication systems, for example, a long term evolution (Long Term Evolution, LTE) system, an LTE frequency division duplex (Frequency Division Duplex, FDD) system, an LTE time division duplex (Time Division Duplex, TDD) system, a 5th Generation (5th Generation, 5G) system, or a new radio (New Radio, NR) system. This is not limited herein.

The following further describes the technical solutions provided in this application with reference to the accompanying drawings and embodiments. It should be understood that a system structure and a service scenario provided in embodiments of this application are mainly intended to explain some possible implementations of the technical solutions of this application, and should not be construed as a unique limitation on the technical solutions of this application. A person of ordinary skill in the art may know that, with evolution of a system and emergence of an updated service scenario, the technical solutions provided in this application are also applicable to a same or similar technical problem.

It should be understood that, in the technical solutions provided in embodiments of this application, some repeated parts may not be described again in the following description of specific embodiments, but it should be considered that these specific embodiments are mutually referenced and may be combined.

In a wireless communication system, devices may be classified into devices that provide a wireless network service and devices that use a wireless network service. The devices that provide the wireless network service refer to devices that form a wireless communication network, and may be briefly referred to as network equipments (network equipments) or network elements (network elements). The network devices generally belong to operators or infrastructure providers, and are operated or maintained by these vendors. The network devices may be further classified into radio access network (radio access network, RAN) devices and core network (core network, CN) devices. Typical RAN devices include a base station (base station, BS).

It should be understood that, sometimes, the base station may also be referred to as a wireless access point (access point, AP) or a transmission reception point (transmission reception point, TRP). Specifically, the base station may be a generation NodeB (generation NodeB, gNB) in a 5G new radio (new radio, NR) system or an evolutional NodeB (evolutional NodeB, eNB) in a 4G long term evolution (long term evolution, LTE) system. Base stations can be classified into macro base stations (macro base stations) or micro base stations (micro base stations) based on different physical forms or transmit powers of the base stations. The micro base station, sometimes, is also referred to as a small base station or a small cell (small cell).

The device that uses the wireless network service may be a terminal. A terminal may also be referred to as user equipment (user equipment, UE), a mobile station (mobile station, MS), a mobile terminal (mobile terminal, MT), a terminal device, or the like, and is a device that provides voice or data connectivity for a user, or may be an Internet of Things device. For example, the terminal includes a handheld device or an in-vehicle device that has a wireless connection function. The terminal may be a mobile phone (mobile phone), a tablet computer, a notebook computer, a palmtop computer, a mobile internet device (mobile internet device, MID), a wearable device (for example, a smart watch, a smart band, or a pedometer), an in-vehicle device (for example, an automobile, a bicycle, an electric vehicle, an aircraft, a ship, a train, or a high-speed train), a virtual reality (virtual reality, VR) device, an augmented reality (augmented reality, AR) device, a wireless terminal in industrial control (industrial control), a smart home device (for example, a refrigerator, a television, an air conditioner, or an electricity meter), an intelligent robot, a workshop device, a wireless terminal in self-driving (self-driving), a wireless terminal in remote medical surgery (remote medical surgery), a wireless terminal in a smart grid (smart grid), a wireless terminal in transportation safety (transportation safety), a wireless terminal in a smart city (smart city), a wireless terminal in a smart home (smart home), a flight device (for example, an intelligent robot, a hot balloon, an uncrewed aerial vehicle, or an aircraft), or the like.

To continuously meet increasing requirements of people for a communication rate, a communication system is evolving toward a multi-channel manner, to achieve a proportional increase of a rate and a quantity of channels. For example, a multiple-input multiple-output (multi-input multi-output, MIMO) technology that has been widely used is used in both fourth-generation and fifth-generation mobile communication (4G and 5G) and a wireless local area network (wireless local area network, WLAN) system, to improve a system rate. Take WLAN as an example. The 802.11ac standard formulated in 2013 defines a maximum MIMO scale as 4x4. In 2018, a next-generation 802.11ax standard further increases the MIMO scale to 8x8. The 802.11be standard being developed will support 16x16 MIMO scale. As the MIMO scale increases, a corresponding WLAN peak communication rate increases from Gbps to dozens of Gbps. As the MIMO scale increases, a quantity of analog paths in the communication system increases proportionally. For example, the 4x4 MIMO scale requires four transmitter systems and four receiver systems. A subsequent problem is that power consumption of the system and the MIMO scale increase in proportion, which leads to obvious problems such as costs, heat dissipation, and power consumption of a large-scale MIMO system.

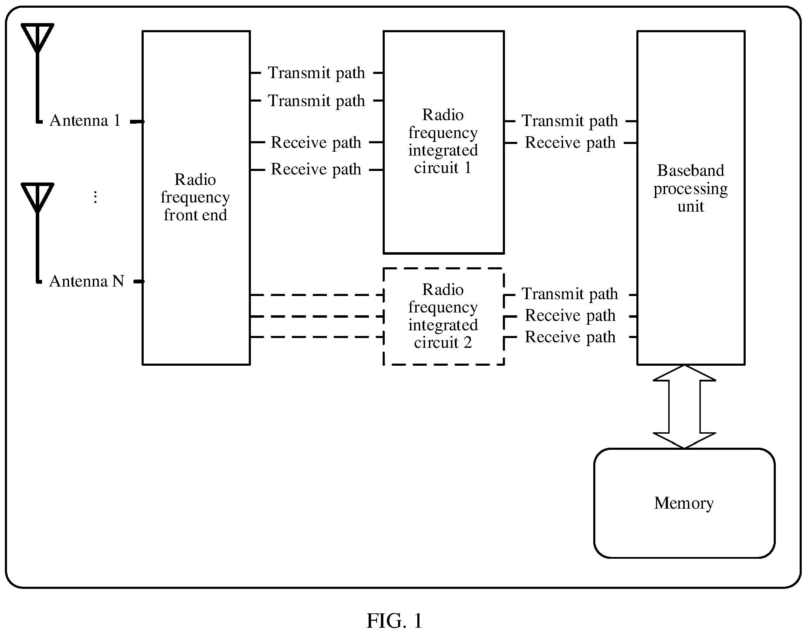

FIG. 1 is a schematic diagram of a structure of a communication system according to an embodiment of this application. The communication system may be a terminal or a network equipment in embodiments of this application. As shown in FIG. 1, the communication system may include a plurality of components, for example, a memory, a baseband processing unit, a radio frequency integrated circuit (radio frequency integrated circuit, RFIC), a radio frequency front end (radio frequency front end, RFFE) device, and an antenna (antenna, ANT). These components may be coupled by using various interconnection buses or other electrical connection manners.

In FIG. 1, an antenna 1 represents a first antenna, an antenna N represents an $N^{th}$ antenna, and N is a positive integer greater than 1. Transmit path (Tx) and receive path (Rx). Different numbers indicate different paths. Each path may represent a signal processing channel. The receive path may include a feedback receive path (FBRx), a primary receive path (PRx), and a diversity receive path (DRx). The path may further be distinguished between a high frequency, a low frequency, and a baseband. The high frequency or the low frequency may be a relative high or low frequency. It should be understood that the marks and the components in FIG. 1 are merely examples, and are merely used as a possible implementation. This embodiment of this application further includes another implementation. For example, a communication system may include more or fewer paths, including more or fewer components.

In FIG. 1, a radio frequency integrated circuit (including an RFIC 1 and one or more optional RFICs 2) and a radio frequency front end device may jointly form a radio frequency sub-system. Based on a receiving or sending circuit of a signal, the radio frequency sub-system may be divided into an RF receive path (RF receive path) and an RF transmit path (RF transmit path). The RF transmit path may transmit a radio frequency signal through an antenna, and the RF receive path may receive the radio frequency signal through the antenna, and perform processing (for example, amplification, filtering, and down-conversion) on the radio frequency signal to obtain a baseband signal, and transmit the baseband signal to the baseband processing unit. The RF transmit path may receive a baseband signal from the baseband processing unit, perform processing (for example, up-conversion, amplification, and filtering) on the baseband signal to obtain a radio frequency signal, and finally radiate the radio frequency signal to space through the antenna. The radio frequency integrated circuit may be referred to as a radio frequency processing chip or a radio frequency chip.

Specifically, the radio frequency sub-system may include electronic devices such as an antenna switch, an antenna tuner, a low noise amplifier (low noise amplifier, LNA), a power amplifier, a mixer (mixer), a local oscillator (local oscillator, LO), and a filter (filter). These electronic devices may be integrated into one or more chips as required. The radio frequency integrated circuit may be referred to as a radio frequency processing chip or a radio frequency chip. The radio frequency front end device may also be an independent chip. The radio frequency chip is sometimes referred to as a receiver (receiver), a transmitter (transmitter), or a transceiver (transceiver). With evolution of technologies, the antenna sometimes may also be considered as a part of the radio frequency sub-system, and may be integrated into a chip of the radio frequency sub-system. The antenna, the radio frequency front end device, and the radio frequency chip can all be manufactured and sold separately. Certainly, the radio frequency sub-system may also use different devices or different integration manners based on power consumption and performance requirements. For example, some devices belonging to the radio frequency front end are integrated into a radio frequency chip, or even both the antenna and the radio frequency front end device are integrated into a radio frequency chip. The radio frequency chip may also be referred to as a radio frequency antenna module or an antenna module.

In addition, because the radio frequency signal is usually an analog signal, and a signal processed by the baseband processing unit is mainly a digital signal, an analog to digital conversion component is further required in the communication system. In this embodiment of this application, the analog to digital conversion component may be disposed in the baseband processing unit, or may be disposed in the radio frequency sub-system. The analog to digital conversion component includes an analog to digital converter (analog to digital converter, ADC) that converts an analog signal into a digital signal, and a digital to analog converter (digital to analog converter, DAC) that converts a digital signal into an analog signal.

The baseband processing unit may include one or more processors. In addition, the baseband processing unit may further include one or more hardware accelerators (hardware accelerators, HACs). The hardware accelerator may be configured to specially complete some sub-functions with relatively high processing overheads, for example, assembling and parsing a data packet (data packet), and encrypting and decrypting a data packet. These sub-functions may also be implemented by using a processor with a general function. However, in consideration of performance or costs, using the hardware accelerator may be more appropriate. In a specific implementation, the hardware accelerator is mainly implemented by using an application specific integrated circuit (application specified integrated circuit, ASIC). Certainly, the hardware accelerator may also include one or more relatively simple processors, for example, an MCU.

In this embodiment of this application, the baseband processing unit and the radio frequency sub-system jointly form a communication sub-system, to provide a wireless communication function for the communication system. Generally, the baseband processing unit is responsible for managing software and hardware resources of the communication sub-system, and may configure an operating parameter of the radio frequency sub-system. A processor of the baseband processing unit may run a sub-operating system of the communication sub-system. The sub-operating system may be an embedded operating system or a real time operating system (real time operating system).

The baseband processing unit may be integrated into one or more chips, and the chip may be referred to as a baseband processing chip or a baseband chip. The baseband processing unit may be used as an independent chip, and the chip may be referred to as a modem (modem) or a modem chip. The baseband processing unit may be manufactured and sold in a unit of the modem chip. The modem chip is sometimes also referred to as a baseband processor or a mobile processor. In addition, the baseband processing unit may be further integrated into a larger chip, and manufactured and sold in a unit of the larger chip. The larger chip may be referred to as a system chip, a chip system, or a system on chip (system on a chip, SoC), or a SoC chip for short. Software components of the baseband processing unit may be built in hardware components of the chip before the chip is delivered, or may be imported from another non-volatile memory to hardware components of the chip after the chip is delivered, or may be downloaded and updated online through the network.

In addition, the communication system further includes a memory. In addition, the baseband processing unit may further include one or more caches. In a specific implementation, the memory may be classified into a volatile memory (volatile memory) and a non-volatile memory (non-volatile memory, NVM). The volatile memory is a memory in which data stored in the memory is lost when a power supply is interrupted. At present, the volatile memory is mainly a random access memory (random access memory, RAM), including a static random access memory (static RAM, SRAM) and a dynamic random access memory (dynamic RAM, DRAM). The non-volatile memory is a memory in which data stored in the memory is not lost even if a power supply is interrupted. A common non-volatile memory includes a read only memory (read only memory, ROM), an optical disc, a magnetic disk, various memories based on a flash memory (flash memory) technology, and the like. Generally, the volatile memory may be used for the memory and the cache, and the non-volatile memory may be used for a mass memory, such as a flash memory.

It should be understood that embodiments of this application are not limited to the communication system shown in FIG. 1. A name of the device shown in FIG. 1 is merely used as an example for description herein, and is not intended to limit a device or a network element included in a communication system architecture to which this application is applicable.

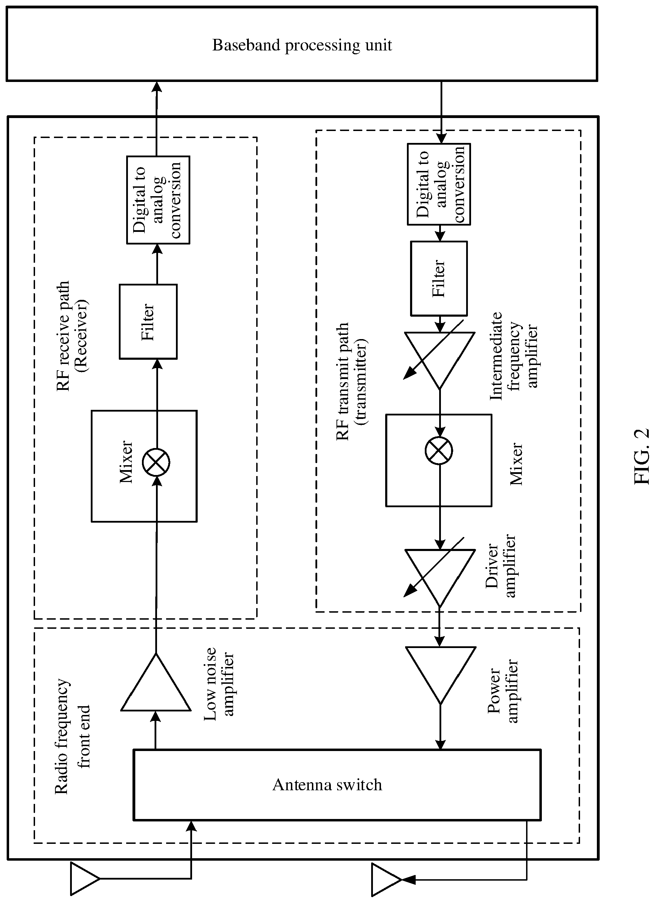

FIG. 2 is a schematic diagram of a structure of another communication system according to an embodiment of this application. FIG. 2 shows some common devices used for radio frequency signal processing in a communication system. It should be understood that although FIG. 2 shows only an RF receive path and an RF transmit path, the communication system in this embodiment of this application is not limited thereto. The communication system may include one or more RF receive paths and one or more RF transmit paths. Each RF transmit path may include devices such as a digital to analog converter (DAC) and a mixer. Before an output signal of each RF transmit path is transmitted through an antenna, power adjustment processing is further performed on the output signal of the radio frequency transmit path through a PA. The RF receive path may include devices such as a mixer, a filter, and an analog to digital converter (ADC). An antenna that is received by the RF receive path from the antenna may be further processed by a device such as a low noise amplifier (low noise amplifier, LNA). FIG. 2 is merely an example. Devices included in the RF receive path and the RF transmit path are not listed one by one in this embodiment of this application.

In a digital communication system, to increase a system capacity, to-be-transmitted information may be encoded, and a symbol may represent one or more binary bits of the information. Each symbol is encoded as a different combination of amplitude and phase modulation of a carrier. A higher modulation requires a higher resolution of encoded and modulated data, and correspondingly, a higher requirement on linearity of the power amplifier.

To ensure fidelity transmission of a modulated variable envelope signal, efficiency of the power amplifier is improved, and power consumption of the power amplifier is reduced. In the radio frequency sub-system, power amplification may be performed through a digital PA (digital PA, DPA). The DPA combines a high efficiency feature of a switching PA and uses a multi-bit quantization technology to convert the analog signal into the digital signal, and then amplifies a quantization level on each quantization bit in the digital signal, so as to obtain an amplified signal based on each amplified quantization level.

For example, when a voltage signal of 20 V is quantized to 10 bits, each quantization step is 20 V/$(2^{10})$=20 mV. That is, the 20 V analog signal may be quantized into a 10-bit digital signal by using 10 quantization levels corresponding to the 10 quantization bits (that is, quantization levels sequentially corresponding to lower bits of the quantization bits are 20 mV, 40 mV, 80 mV, ..., $2^9 \times 20$ mV). Therefore, a quantization level on each bit of the 10 bits is separately amplified, to obtain an amplified signal with relatively good linearity.

To ensure a linearity requirement of the DPA on each quantization level in the digital signal, a binary encoding mode of the digital signal may be converted into a thermometer encoding mode, and a quantization bit value on each quantization bit may be represented by an encoded value by performing the thermometer encoding. Therefore, the corresponding quantization level on each quantization bit may also be determined based on the encoded value by performing the thermometer encoding.

For example, a quantity of transistors that correspondingly amplify a quantization level on an $i^{th}$ quantization bit is $2^i$-1, where i is an integer less than K. K is a quantity of quantization bits corresponding to a to-be-amplified signal. A quantization level correspondingly amplified by each transistor may also be determined by the $i^{th}$ quantization bit and the quantization step. That is, when a quantization level of 80 mV is amplified, a quantity of transistors that correspondingly amplify a quantization level is $2^2$-1=3. When a quantization level of $2^9 \times 20$ mV is amplified, a quantity of transistors that correspondingly amplify the amplified quantization level is $2^9$-1. That is, each quantization level in the encoded digital signal is sent to a transistor that correspondingly amplifies the quantization level for power amplification, so as to ensure a linearity requirement of the DPA amplified signal and improve efficiency of the power amplifier.

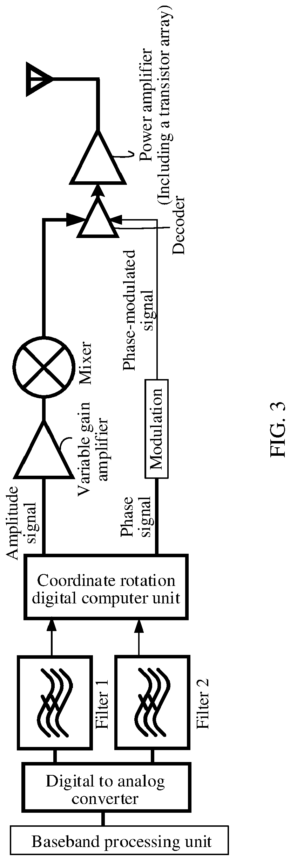

The following uses Polar and IQ architectures to describe a DPA architecture. As shown in FIG. 3, in the polar architecture, a DPA receives an analog signal of a baseband processing unit. The analog signal may be quantized into a digital signal through a DAC module. During converting the analog signal into the digital signal, to improve linearity of a system, a binary code may be converted into a thermometer code. The digital signal passes through a corresponding filter, for example, an up-sampling interpolation filter, to convert a low-frequency signal of baseband data into a high-frequency signal having a radio frequency carrier, so as to improve an out-of-band signal-to-noise ratio of the signal, thereby meeting a requirement of a spectrum of a protocol. Then, a coordinate rotation digital computer (coordinate rotation digital computer, CORDIC) unit divides the digital signal into an amplitude signal and a phase signal. The amplitude signal is input to the DPA. The phase signal is converted into a radio frequency signal (also a phase-modulated (phase-modulated, PM) signal) by the modulator and input to the DPA. The DPA combines the input amplitude signal and the input phase-modulated signal, amplifies the signal, and outputs the amplified signal to the antenna.

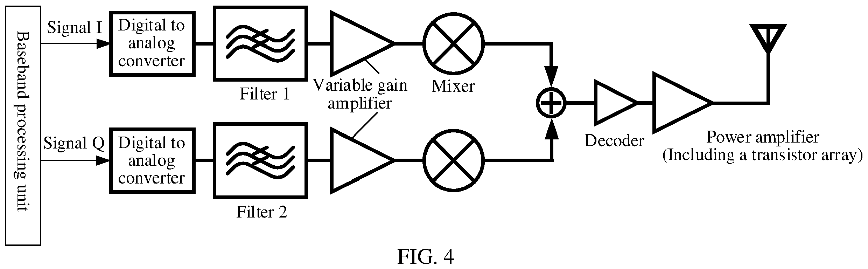

As shown in FIG. 4, in an IQ architecture, an input signal includes an in-phase input signal I and a quadrature input signal Q, and the signal I and the signal Q in the input signal have a 90-degree phase difference. The signal I and the signal Q are input into a digital to analog converter (DAC) 1 and a digital to analog converter (DAC) 2, and the digital to analog converter 1 performs digital to analog conversion on the signal I and outputs the signal I to a filter 1. For example, the filter 1 may be a low-pass filter, and the filter 1 is configured to filter out a high frequency in a signal output by the digital to analog converter 1. After performing digital to analog conversion on the signal Q of the digital to analog converter 2, the digital to analog converter 2 outputs the signal Q to the filter 2. For example, the filter 2 may be a low-pass filter, and the filter 2 is configured to filter out a high frequency in a signal output by the digital to analog converter 2. A mixer performs frequency mixing on the signals output by the filter 1 and the filter 2, and outputs a radio frequency carrier. Amplitude modulation (that is, power amplification) of the radio frequency carrier is implemented through the DPA. The two signals, namely, the signal I and the signal Q, are input to a quantized DPA for combination, and are finally output to the antenna.

The following uses decoding and amplification of an amplitude signal in the polar architecture in FIG. 3 as an example for description. For an amplification process of the signal I and the signal Q in the IQ architecture, refer to a process of decoding and driving amplification of the amplitude signal in the example in FIG. 4.

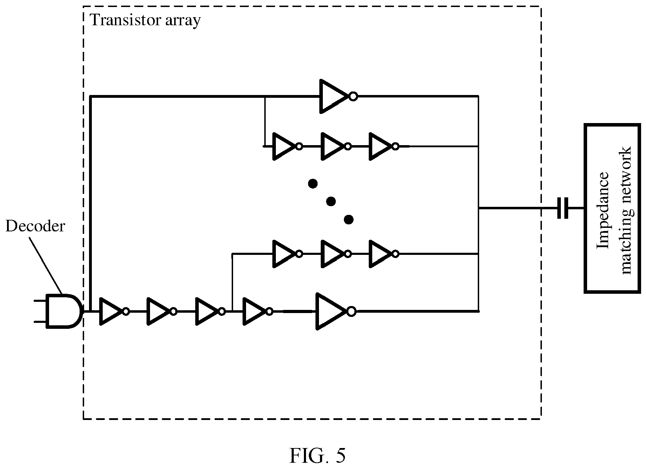

As shown in FIG. 5, the DPA may include a decoder and a transistor array. The decoder is configured to receive a digital signal sent by the baseband processing unit. For example, a transistor in the transistor array may be a switched-capacitor power amplifier (switched-capacitor power amplifier, SCPA). With reference to FIG. 3, the amplitude signal in the digital signal is transferred to the decoder of the DPA. When the amplitude signal is quantized into K bits, the amplitude signal may include quantization bit values corresponding to K quantization bits, and the quantization bit value may be represented as an amplitude control word (amplitude control word, ACW). The decoder is configured to decode the amplitude control word in the amplitude signal, determine a corresponding quantization level of each quantization bit in the digital signal, and determine a corresponding transistor in the DPA that is driven by each quantization level.

In a possible implementation, the ACW is binary encoded. For example, it is determined that the ACW is 4 bits, that is, a quantity of quantization bits of the DPA is 4. Each bit corresponds to a transistor that controls a DPA. In this case, the transistor array in the DPA includes four transistors. Correspondingly, the decoder may determine, through the ACW, a switch status of a transistor corresponding to each bit. For example, when the ACW is 1010, in an order from a low bit to a high bit, it may be determined that a $0^{th}$ bit is 0, a corresponding transistor is in a non-operating state, a first bit is 1, a corresponding transistor is configured to amplify a quantization level corresponding to the first bit, a second bit is 0, a corresponding transistor is in the non-operating state, a third bit is 1, and a corresponding transistor is configured to amplify a quantization level corresponding to the third bit.

The decoder decodes the received digital signal, and generates a corresponding quantization level after determining the transistor in a driven DPA. With reference to a phase-modulated signal, a digital gate combines the phase-modulated signal with the quantization level from the decoder, to generate square wave vectors of the quantization level. After the square wave vectors are fed into a transistor that amplifies the quantization level, the quantization level is amplified. All the amplified quantization levels are transferred to an impedance matching network, and the impedance matching network is configured to adjust load impedance of the DPA.

To meet a linearity requirement of a radio frequency system in different modulation schemes, quantization precision of the digital to analog conversion and linearity of the power amplification need to be ensured.

It is considered that the DPA has relatively poor linearity for a binary-encoded digital signal, when a requirement for quantization precision of the digital to analog conversion is relatively high, for example, a quantity of quantization bits of the DPA is 15 bits, in this case, a transistor that is driven by the binary code cannot be directly used to implement power amplification. In a possible implementation, each encoded bit is implemented by a transistor controlled by the thermometer code, that is, each time a quantization bit is added, a quantity of transistors added in the DPA increases exponentially. For example, a quantity of quantization bits is K, and a quantity of transistors required for amplifying a quantization level corresponding to an $i^{th}$ quantization bit is $2^i$, where i is an integer less than K. The quantity of transistors in the DPA reached $2^K$-1.

For example, to obtain that the quantization bits of the ACW are 15 bits, that is, the quantity of quantization bits of the DPA is 15, and each quantization bit is implemented by a transistor controlled by thermometer encoding, the quantity of transistors in the DPA reaches $2^{15}$-1. For example, in an order from a low bit to a high bit, a quantization level corresponding to a $0^{th}$ bit is amplified through one transistor, a first bit is correspondingly amplified through three transistors, a second bit is correspondingly amplified through three transistors, a third bit is correspondingly amplified through seven transistors, ..., and a seventeenth bit is correspondingly controlled by $2^{14}$-1 transistors.

To reduce the quantity of transistors, in another possible manner, the encoding may be performed in a manner of hybrid encoding of a thermometer code and a binary code, and take 15 bits are used as an example. The high-order 10 bits are implemented by a transistor that uses the thermometer code, and the low-order 5 bits are implemented by a transistor that uses the binary code. Correspondingly, the decoder decodes each bit in the 10 bits according to a high-order thermometer encoding manner, so as to correspondingly control the transistor of each bit in the 10 bits, and decodes each bit in the 5 bits according to a low-order binary encoding manner, so as to correspondingly control the transistor of each bit in the 5 bits. In this case, the DPA includes (1023 + 5) transistors. In addition, during layout design, a layout requirement needs to be considered for the DPA. For example, a transistor array of 32 rows × 32 columns is arranged, which increases difficulty in layout design of a decoder and a transistor array of the DPA in an entire circuit.

Overall, the quantity of transistors increases exponentially with the quantity of quantization bits of transistors in the DPA. The quantization precision of the DPA is related to the quantity of transistors, and the two are exponentially related. If the precision needs to be further improved, for example, the DPA precision of 16 bits, the quantity of transistors may reach (2047+5). As the quantity of transistors increases, the design difficulty of a layout is greatly increased, and a more complex decoder needs to be designed, which additionally increases the power consumption of the digital amplifier.

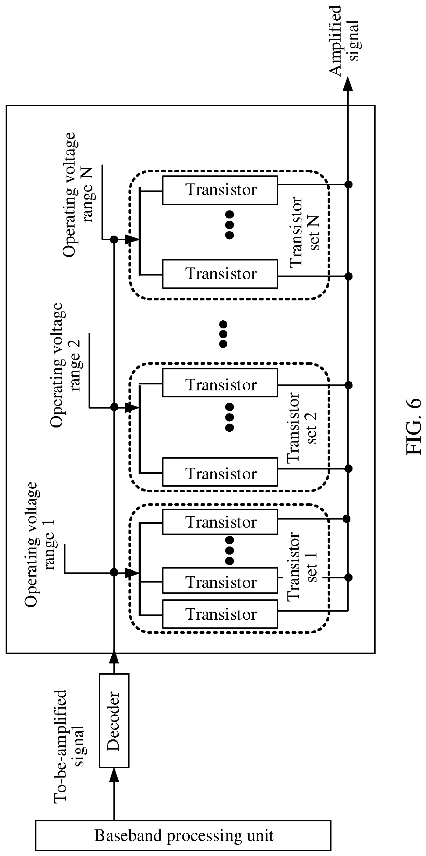

Based on the foregoing problem, this application provides a possible structure of a digital power amplifier. As shown in FIG. 6, the digital power amplifier includes a decoder and N transistor sets. The decoder includes an input end and N groups of output ends, the input end of the decoder is connected to a baseband processing unit, the N groups of output ends of the decoder are respectively connected to the N transistor sets, and the N transistor sets operate within at least two different operating voltage ranges.

The decoder is configured to receive K quantization levels corresponding to a to-be-amplified signal from the baseband processing unit, and send a target quantization level that is within a same operating voltage range and that is of the K quantization levels to a transistor set that operates within the operating voltage range, where N is a positive integer greater than 1, and K is a positive integer. The N transistor sets are configured to respectively amplify target quantization levels received by the N transistor sets.

In some embodiments, at least two different operating voltage ranges of the N transistor sets may be determined by a voltage range of the to-be-amplified signal. The to-be-amplified signal may determine a corresponding voltage range based on a modulation scheme.

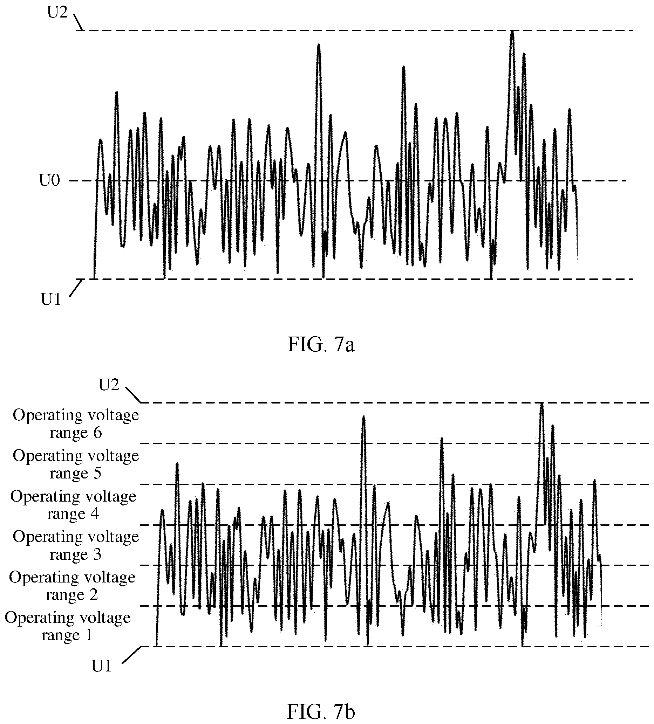

For example, FIG. 7a is a time envelope signal of an "OFDM+quadrature amplitude modulation (quadrature amplitude modulation, QAM) signal. It may be determined, based on the time envelope signal, that the voltage range of the to-be-amplified signal is [U1, U2]. U1 is less than U2, and U1 and U2 are rational numbers. Therefore, division is performed based on the voltage range of the to-be-amplified signal, to obtain at least two voltage ranges. For example, a voltage range 1 is included, that is, [U1, U0], and a voltage range 2 is included, that is, [U0, U2]. U0 is less than U2 and greater than U1. U0 is a rational number. In this case, operating voltage ranges corresponding to the N transistor sets include at least the voltage range 1 or the voltage range 2. In some examples, an operating voltage range 1 of at least one transistor set in the N transistor sets includes at least the voltage range 1, for example, [U1, U0'], where U0' is greater than or equal to U0, U0 is less than U2 and greater than U1, and U0' is a rational number. The at least one transistor set is configured to amplify a quantization level within the operating voltage range 1.

In some embodiments, each of the N transistor sets corresponds to one or more of K quantization bits. Therefore, the decoder may determine, based on the one or more of the K quantization bits corresponding to each of the N transistor sets, a target quantization bit of the target quantization level in the K quantization bits, and send the target quantization level to a transistor set corresponding to the target quantization bit.

In this application, there may also be a plurality of forms of an operating voltage range corresponding to a transistor set. Correspondingly, each of the N transistor sets may be specifically corresponding to one or more of the K quantization bits in a plurality of manners. The following uses manner 1 to manner 2 as an example for description.

Manner 1: At least two transistor sets in the N transistor sets operate within a first operating voltage range, the first operating voltage range includes at least two voltage sub-ranges in which voltage values do not overlap, and the at least two voltage sub-ranges are in a one-to-one correspondence with the at least two transistor sets.

The decoder is configured to send a target quantization level that is within a same voltage sub-range and that is of the K quantization levels to a transistor set corresponding to the voltage sub-range.

The transistor set corresponding to the voltage sub-range is configured to amplify a received quantization level within the voltage sub-range.

For example, the first operating voltage range is a range of the to-be-amplified signal, that is, [U1, U2]. The first operating voltage range includes at least two voltage sub-ranges in which voltage values do not overlap: a voltage sub-range 1, [U1, V1], and a voltage sub-range 2, [V1, U2].

Each voltage sub-range may correspond to a quantity of quantization bits within the voltage sub-range, so that the quantity of quantization bits of the first operating voltage range is determined based on a sum of the quantities of quantization bits within the voltage sub-ranges. Correspondingly, the quantity of transistors in the transistor set may be determined based on the quantity (K) of quantization bits of the DPA and the quantity of quantization bits that are set within each voltage sub-range and that are corresponding to the voltage sub-range.

In this application, a quantity of quantization bits corresponding to each voltage range or voltage sub-range may be implemented in a plurality of manners. The following uses a voltage range as an example, and uses a manner A to a manner C as an example for description.

With reference to the manner 1, in the manner A, the quantity of quantization bits of each voltage sub-range is the same. That is, when the quantity of quantization bits corresponding to the first operating voltage range is 12, the quantity of quantization bits of each voltage sub-range may be 6.

It is considered that the quantization bit of the transistor set is related to the operating voltage range corresponding to the transistor set. For example, the voltage sub-range 1 corresponds to a DPA quantization bit that is a low-order quantization bit, and the voltage sub-range 2 corresponds to a DPA quantization bit that is a high-order quantization bit.

With reference to FIG. 7a, the voltage sub-range 1 corresponds to six low-order quantization bits of the DPA quantization bits, and the voltage sub-range 2 corresponds to six high-order quantization bits of the DPA quantization bits. The voltage sub-range 1 corresponds to a transistor that is of the transistor set and that is configured to amplify a quantization level in the voltage sub-range 1, and the voltage sub-range 2 corresponds to a transistor that is of the transistor set and that is configured to amplify a quantization level in the voltage sub-range 2. Therefore, a maximum quantity of transistors required for the first operating voltage range is $2^6$-1. In this case, a quantity of transistors that amplify the first operating voltage range in the DPA is 127.

Optionally, a low-bit transistor set corresponding to the voltage sub-range 1 may further be combined with a binary encoding manner, for example, including three binary-encoded bits and three thermometer-encoded bits. In this case, a quantity of transistors in the transistor set corresponding to a first voltage range is $2^3$+3. In this case, a quantity of transistors in the DPA is 64+11=75.

For another example, as shown in FIG. 7b, a voltage range of an envelope amplitude of the time envelope signal shown in FIG. 7a is divided into six voltage ranges. When one voltage range corresponds to one operating voltage range of one transistor set, six operating voltage ranges of the six transistor sets may be correspondingly determined. As shown in FIG. 7b, an example in which quantities of quantization bits corresponding to all operating voltage ranges are the same is still used. When the quantity of quantization bits of the DPA is 12, the quantity of quantization bits of each operating voltage range may be 2. Therefore, a maximum quantity of transistors required for each voltage range is $2^2$-1. In this case, the quantity of transistors in the DPA is 24.

It can be learned that, by using the foregoing method, a quantity of transistors required for the same quantity of quantization bits of the DPA may be greatly reduced. For example, after the quantity of transistors and the quantity of quantization bits of the to-be-amplified signal are determined, N may be correspondingly set, so as to meet requirements of DPA precision, layout design, and cost control.

Based on that the N transistor sets operate within different consecutive N voltage ranges, different power supplies are used to supply power to corresponding transistor sets within different voltage ranges. The voltage range of the analog signal amplified by the DPA is obtained by combining the N voltage ranges. Power amplifiers of corresponding transistor sets are driven through different voltage ranges, so as to perform power amplification on IQ signals of different amplitudes.

With reference to FIG. 7b, a magnitude of an envelope amplitude of the time envelope signal is divided into six consecutive voltage ranges, including [0, 0.6] V, [0.6, 1.2] V, ..., [3, 3.6] V. Therefore, six transistor sets may be set, and an operating voltage range of each transistor set includes at least one voltage range, to amplify the quantization level within the voltage range.

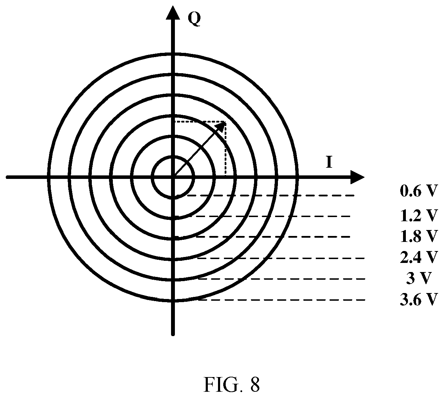

For example, as shown in FIG. 8, when a voltage amplitude of the to-be-amplified signal at a moment is 2 V, it may be determined that a corresponding quantization level is in a part of a first voltage range [0,0.6 V], a second voltage range [0.6 V, 1.2 V], and a third voltage range [1.2 V, 1.8 V]. Still, each voltage range corresponds to two quantization bits. In this case, a quantization bit value corresponding to the signal may be 0000000011111, that is, two lowest bits correspondingly drive transistors in the transistor set corresponding to the first voltage range, and are configured to amplify two quantization levels on the two lowest bits. The two consecutive bits correspondingly drive transistors corresponding to the second voltage range, and are configured to amplify two quantization levels on the two bits corresponding to the voltage range. The fifth bit correspondingly drives some transistors within the third voltage range, which are configured to amplify a quantization level on the fifth bit corresponding to the voltage range. In this way, quantization levels on the five quantization bits are amplified.

With reference to the manner 1, in a manner B, a magnitude of a voltage range is determined based on a probability that a voltage value of an envelope signal of an analog signal of the to-be-amplified signal appears within the operating voltage range. Alternatively, a quantity of quantization bits corresponding to a voltage range is determined based on a probability that a voltage value of an envelope signal of an analog signal of the to-be-amplified signal appears within the operating voltage range.

Correspondingly, any operating voltage range in the N operating voltage ranges, a magnitude of the operating voltage range or a quantity of quantization bits corresponding to a transistor set that operates within the operating voltage range is related to a probability that a voltage value of an envelope signal of an analog signal of the to-be-amplified signal appears within the operating voltage range.

With reference to FIG. 7a, an amplitude of the time envelope signal changes significantly, and a larger amplitude of the envelope signal indicates a lower probability, and a smaller amplitude of the envelope signal indicates a higher probability of occurrence of an amplitude value of the envelope signal.

Therefore, it is considered that a lower probability of occurrence of an amplitude of the envelope signal indicates a lower probability that the DPA amplifies the amplitude of the envelope signal, to reduce costs of the DPA, N voltage ranges may be divided based on the probability of occurrence of the amplitude of the envelope signal. A voltage range with a higher probability is smaller, and a voltage range with a lower probability is larger, so as to ensure a linearity requirement of signal transmission.

With reference to the manner 1, in a manner C, a magnitude of the voltage range is determined based on a probability that the voltage range corresponds to power spectral density of an envelope signal of the to-be-amplified signal. Alternatively, a quantity of quantization bits corresponding to the voltage range is determined based on a probability that the voltage range corresponds to power spectral density of an envelope signal of the to-be-amplified signal.

Correspondingly, for any operating voltage range in the N operating voltage ranges, a magnitude of the operating voltage range or a quantity of quantization bits of a transistor set that operates within the operating voltage range is related to a probability that power spectral density of an envelope signal of an analog signal of the to-be-amplified signal appears within the operating voltage range.

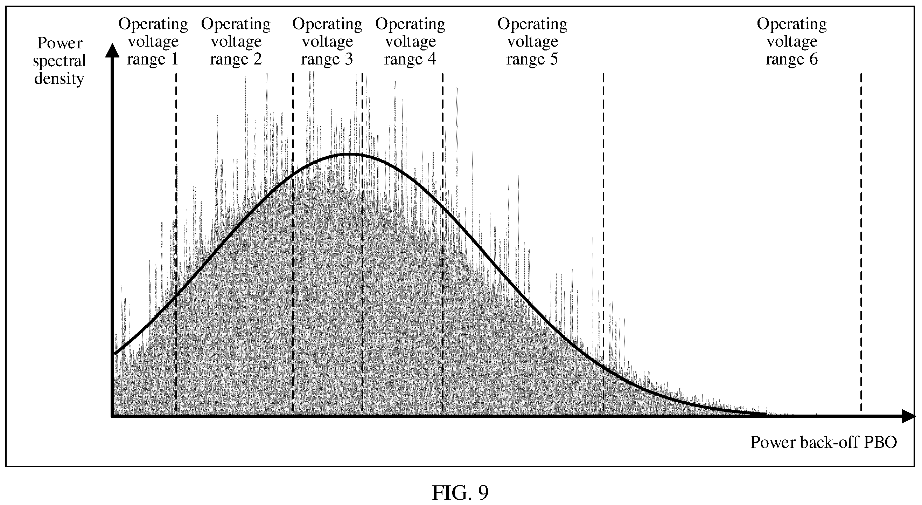

As shown in FIG. 9, a horizontal axis in FIG. 9 is a normalized value obtained by taking a logarithm of an amplitude value of an envelope signal of an analog signal of a to-be-amplified signal, and may correspond to a power back-off amount of a transistor. When the transistor operates within a voltage range corresponding to a power back-off range, relatively high efficiency of the transistor may be ensured. A vertical axis is power spectral density corresponding to different amplitude values, that is, may correspond to a probability that a transistor amplifies a quantization level in different voltage ranges. It can be seen that, for a time envelope signal of an "OFDM+QAM" signal, a probability that amplitude values of different envelope signals appear is different. The voltage range 3 and the voltage range 4 correspond to the highest probability, and the voltage range 1 and the voltage range 6 correspond to the lowest probability.

Further, it is considered that a region with higher power spectral density has a higher frequency of the transistor that operates within the voltage range, and efficiency may be reduced after power back-off, a region with a higher power spectral density probability may be divided into a smaller voltage range, so as to reduce a power back-off value of the transistor that amplifies the quantization level within the voltage range, and ensure the linearity requirement of signal transmission.

For example, when the N transistor sets correspondingly amplify the quantization levels within the N voltage ranges respectively, and the N voltage ranges are continuous and do not overlap, the quantity of quantization bits of the DPA is a sum of quantities of quantization bits of the quantization levels that are correspondingly amplified by the N transistor sets and that are of the N voltage ranges. Therefore, after the quantization bits of the quantization levels that are correspondingly amplified by the N transistor sets and that are of the N voltage ranges and the quantization levels are determined, the quantity of transistors in the transistor sets that amplify the quantization levels within the voltage range may be correspondingly determined. The following uses a manner B 1 and a manner B2 as examples for description.

With reference to the manner 1 and the manner B, in the manner B1, a quantity of quantization bits corresponding to a voltage range is related to a magnitude of the voltage range. For example, when the voltage range is relatively large, a relatively large quantity of quantization bits may be set. With reference to FIG. 9, when a first voltage range is relatively large, a relatively large quantity of quantization bits may be set, for example, three bits, and when a third voltage range is relatively small, a relatively small quantity of quantization bits may be set, for example, two bits.

With reference to the manner 1 and the manner B, in the manner B2, a quantity of quantization bits corresponding to the voltage range may be determined based on a probability that a voltage range of an envelope signal of an analog signal of the to-be-amplified signal appears within the voltage range.

For example, within the voltage range of the envelope signal of the analog signal, when the probability of occurrence of the voltage range is relatively high, a relatively large quantity of quantization bits may be set. With reference to FIG. 9, when a probability that the first voltage range appears within the voltage range of the envelope signal of the analog signal is relatively small, a relatively small quantity of quantization bits, for example, two bits, may be set. When the third voltage range is relatively small, a relatively large quantity of quantization bits, for example, three bits, may be set. When the fourth voltage range is relatively small, a relatively large quantity of quantization bits, for example, four bits, may be set. When a probability that the sixth voltage appears within the voltage range of the envelope signal of the analog signal is relatively small, a relatively small quantity of quantization bits, for example, one bit, may be set. For example, in an order from a low bit to a high bit, the bits may sequentially correspond to 2.6 bits, 3 bits, 4 bits, 3 bits, 3 bits, 2 bits, and 1 bit.

With reference to the manner 1 and the manner C, in a scenario of the N continuous voltage ranges, quantization bits respectively corresponding to the N transistor sets form quantization bits of the DPA. In this case, a voltage range of quantization levels correspondingly amplified by each transistor set may be determined based on the power spectral density in FIG. 9. Correspondingly, a quantity of quantization bits corresponding to each voltage range may also be determined based on the power spectral density in FIG. 9. For example, the quantity of quantization bits of the voltage range is determined based on the magnitude of the voltage range. For another example, the quantity of quantization bits of the voltage range is determined based on the probability of the power spectral density corresponding to the voltage range in the power spectral density of the envelope signal of the analog signal of the to-be-amplified signal. For a specific manner, refer to the manner B1 and the manner B2. Details are not described herein again.

In this manner, quantization precision of a transistor set that operates in a region with a higher power spectral density is higher, so that a linearity requirement of the to-be-amplified signal may be better ensured.

Manner 2: N voltage ranges of quantization levels correspondingly amplified by N transistor sets may be discontinuous. For example, at least two voltage ranges may overlap. The overlap herein may be partial overlap, or may be full overlap.

In some embodiments, two transistor sets in the N transistor sets correspond to a same operating voltage range, and the two transistor sets correspond to different quantities of quantization bits.

In this case, the decoder may be further configured to: determine, from the K quantization levels, a target quantization level within the operating voltage range corresponding to the two transistor sets; select, from the two transistor sets, a target transistor set whose quantity of quantization bits is the same as a quantity of quantization bits corresponding to the target quantization level; and send the target quantization level corresponding to the operating voltage range to the target transistor set.

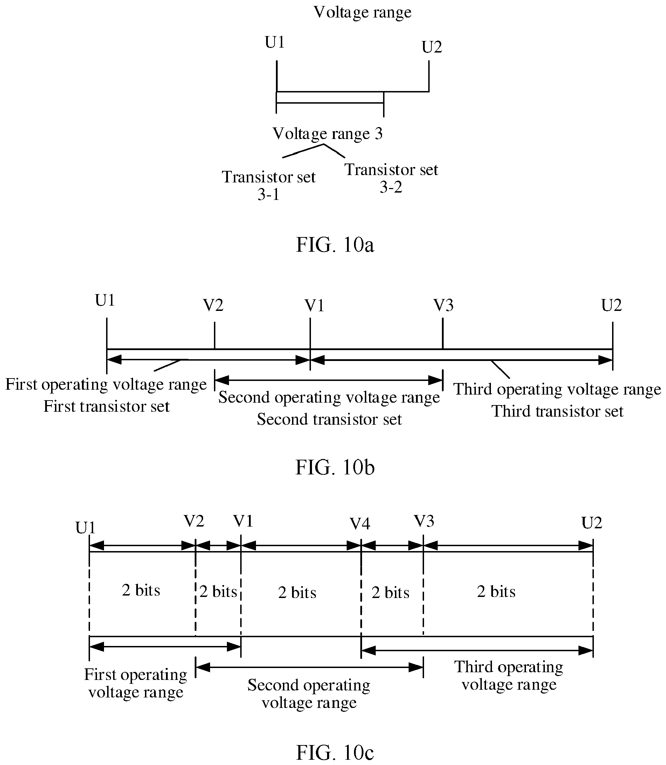

For example, as shown in FIG. 10a, the N transistor sets include a transistor set 3-1 and a transistor set 3-2, an operating voltage range corresponding to the transistor set 3-1 includes a voltage range 3, an operating voltage range corresponding to the transistor set 3-2 includes a voltage range 3, and the voltage range 3 is less than a voltage range corresponding to the to-be-amplified signal. A quantity of quantization bits corresponding to the transistor set 3-1 is K1, and a quantity of quantization bits corresponding to the transistor set 3-2 is K2, where K1 and K2 are positive integers less than K. When K is a different value, that is, when quantization precision of the to-be-amplified signal is different, a quantity of quantization bits of a quantization level within an input voltage range 3 may change. A target transistor set whose quantity is the same as the quantity of quantization bits corresponding to the target quantization level may be selected based on the quantity of quantization bits corresponding to the transistor set 3-1 and the quantity of quantization bits corresponding to the transistor set 3-2. For example, when the quantity of quantization bits corresponding to the target quantization level within the voltage range 3 is K1, in this case, it may be determined that the target transistor set is the transistor set 3-1. Therefore, the decoder inputs K1 quantization levels within the voltage range 3 to the transistor set 3-1, to implement amplification of the K1 quantization levels.

Therefore, based on different requirements of quantization precision, a transistor set that matches quantization precision in a corresponding voltage range is selected, thereby improving flexibility and an application range of the DPA amplified signal.

The following uses a voltage range corresponding to the to-be-amplified signal as an example for description. By setting operating voltage ranges corresponding to different transistor sets and voltage ranges of quantization levels correspondingly amplified by different transistor sets, quantization precision of the to-be-amplified signal is adjusted. The following uses a manner 2-1 and a manner 2-2 as examples.

Manner 2-1: As shown in FIG. 10b, the voltage range of the envelope amplitude of the time envelope signal shown in FIG. 7a is divided into four voltage ranges, which are [U1, V2], [V2, V1], [V1, V3] and [V3, U2].

In this case, it is assumed that an operating voltage range of a first transistor set corresponds to [U1, V1], an operating voltage range of a second transistor set corresponds to [V2, V3], and an operating voltage range of a third transistor set corresponds to [V3, U2]. V1 is greater than V2, and V3 is greater than V4. A quantity of quantization bits of the first transistor set is 7, a quantity of quantization bits of the second transistor set is 8, and a quantity of quantization bits of the third transistor set is 5.

The decoder may determine, based on the quantity of quantization bits corresponding to each voltage range and the quantity of quantization bits corresponding to each transistor set, a quantization level correspondingly amplified by each transistor set within the voltage range.

For example, when the quantity of quantization bits of the DPA is 12, and the quantities of quantization bits of each voltage range corresponding to ascending order are 3, 4, 4, and 2, seven quantization levels within the voltage ranges [U1, V2] and [V2, V1] may be amplified through the first transistor set. Six quantization levels within the voltage range [V1, V3], [V3, U2] are amplified through the third transistor set.

For example, when the quantity of quantization bits of the DPA is 10, and the quantities of quantization bits of the voltage ranges corresponding to the ascending order are 2, 4, 4, and 1, two quantization levels within the voltage range [U1, V2] may be amplified through the first transistor set, and eight quantization levels within the voltage ranges [V2, V1] and [V1, V3] may be amplified through the second transistor set. One quantization level within the voltage range [V4, U2] is amplified through the third transistor set.

Manner 2-2: Voltage ranges of quantization levels correspondingly amplified by the N transistor sets partially overlap.

For example, as shown in FIG. 10c, the voltage range of the envelope amplitude of the time envelope signal shown in FIG. 7a is divided into five voltage ranges, for example, [U1, V2], [V2, V1], [V1, V4], [V4, V3] and [V3, U2] in ascending order.

Correspondingly, operating voltage ranges of three transistor sets are [U1, V1], [V2, V3], and [V1, U2], and amplified voltage ranges of the three transistor sets are also [U1, V1], [V2, V3], and [V1, U2]. V1 is greater than V2, and U2 is greater than V1.

For example, with reference to FIG. 10c, three non-overlapping voltage ranges may be determined: a first non-overlapping voltage range corresponds to [U1, V2], a second non-overlapping voltage range corresponds to [V2, V4], and a third non-overlapping voltage range corresponds to [V4, U2]. Two overlapping voltage ranges are determined: a first overlapping voltage range corresponds to [V2, V1], and a second overlapping voltage range corresponds to [V4, V3]. Within the overlapping voltage range, a target transistor set corresponding to the quantization bit may be correspondingly selected.

For example, when the quantity of quantization bits of the DPA is 10, it is assumed that the decoder may sequentially determine that the quantity of quantization bits corresponding to the voltage range is 2. In this case, four quantization levels within the first to second voltage ranges may be amplified through the first transistor set, quantization levels of two quantization bits within the third voltage range may be amplified through the second transistor set, and four quantization levels within the fourth to fifth voltage ranges may be amplified through the third transistor set. Certainly, the amplified quantization level of each transistor set may be further determined in another manner, provided that the transistor set is capable of amplifying the quantization level.

According to the foregoing method, different operating voltage ranges may be selected based on different signals to amplify the signal. Alternatively, different operating voltage ranges may be selected based on different quantization precision requirements to amplify the signal. Therefore, requirements of quantization precision of different signals may be more flexibly adapted, and flexibility of the DPA is improved without redesigning the layout of the DPA.

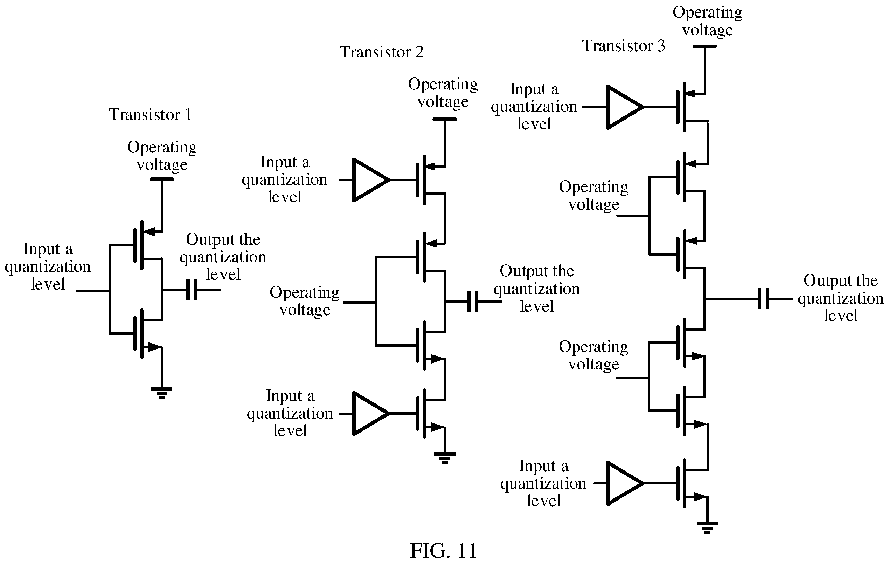

In some embodiments, it is considered that different operating voltages of the transistor sets, the operating voltages of the transistor sets may be different. To ensure a normal operation of the circuit, structures of transistors in different transistor sets may also be different. For example, as shown in FIG. 11, to prevent a transistor from being broken down, a higher operating voltage indicates a larger quantity of transistors that need to be stacked. For example, the transistor in this application may be a MOS transistor, or may be another transistor of a switching PA. This is not limited herein. Using a 40 nm CMOS process as an example, three types of transistors shown in FIG. 11 are implemented based on the process, and maximum values of operating voltages of the three types of transistors are 1.2 V, 2.4 V, and 3.6 V. Therefore, a transistor 1 may be used in a transistor set corresponding to a voltage range below 1.2 V, a transistor 2 may be used in a transistor set corresponding to a voltage range below 2.4 V, and a transistor 3 may be used in a transistor set corresponding to a voltage range below 2.4 V. It should be noted that because the transistor 2 and the transistor 3 include superposition of a plurality of transistors, there may be a plurality of power supply ports. For example, the transistor 2 includes power supply ports of two operating voltages, and the transistor 3 includes power supply ports of three operating voltages. A specific power supply voltage may be set according to an actual requirement, and is not limited herein.

In some embodiments, the transistor set includes at least one transistor, and the at least one transistor uses a same operating voltage. Therefore, a circuit design solution may be simplified, and layout design costs and process difficulty may be reduced.

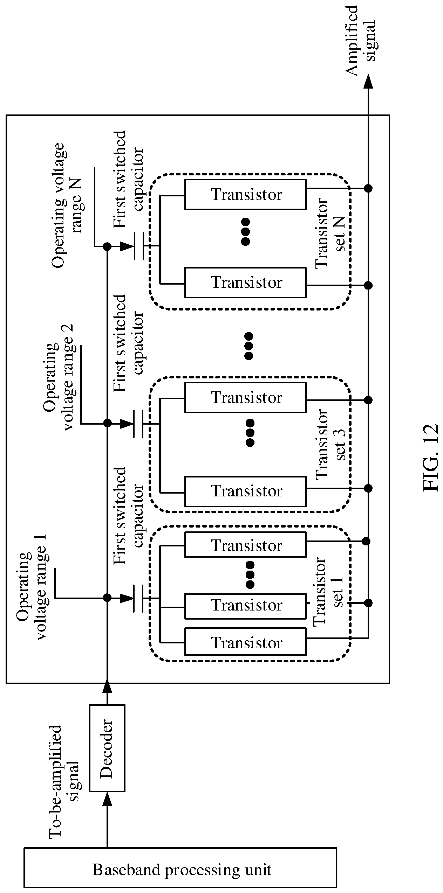

For example, as shown in FIG. 12, the transistor set may further include a first switched capacitor, and the first switched capacitor is connected to all transistors in the transistor set. The first switched capacitor is configured to receive a quantization level corresponding to the transistor set, and transmit the quantization level to a connected transistor. The transistor is configured to amplify the quantization level sent by the switched capacitor.

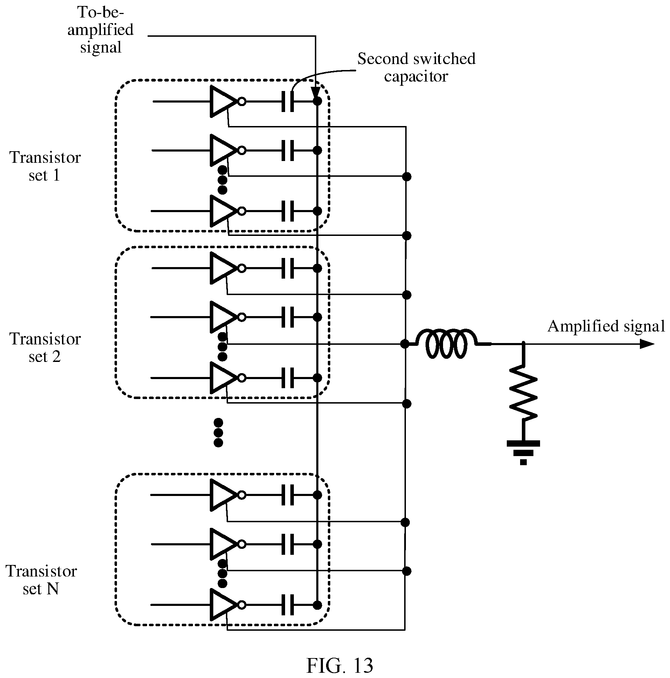

For another example, as shown in FIG. 13, the transistor set may further include: each second switched capacitor connected to each transistor in the transistor set. Each second switched capacitor is configured to receive a quantization level corresponding to the transistor set, and transmit the quantization level to a connected transistor. The transistor is configured to amplify the quantization level sent by the switched capacitor.

In some other embodiments, operating voltages of all transistors in the transistor set may be different operating voltages, or may be a same operating voltage. Transistors in each transistor set operate at different operating voltages. The transistor in the transistor set uses a switched capacitor architecture, and each switched capacitor is controlled to be turned on or off by using a quantization level correspondingly amplified by each transistor.

According to the foregoing method, because the first switched capacitor or the second switched capacitor in the transistor set, power supplies between different transistor sets may not affect each other, thereby reducing power consumption of the DPA.

In a possible implementation, the DPA may include an impedance matching network, and the impedance matching network may be configured to match impedance of the N transistor sets. For example, a resistor shown in FIG. 13 may be configured to match impedance of the N transistor sets.

Optionally, as shown in FIG. 13, the DPA may further include an inductor. The inductor is configured to implement resonance with a capacitor (for example, a first switched capacitor or a second switched capacitor) in the DPA, and control an operating frequency of the DPA.

In a possible implementation, operating voltages of all transistors in the transistor set are a same operating voltage. To simplify an implementation of a circuit and reduce difficulty of layout design.

The following analyzes and calculates efficiency of the DPA in this application.

$$V_{outn} = \frac{2}{\pi} * \text{Vn} * Ratio\_\text{n} * Cn/(Ctotal)$$

$$P_{outn} = \frac{0.5 * V_{\text{out}}^2}{R_L}$$

Voutn is an output voltage of an $n^{\text{th}}$ transistor set, Vn is an operating voltage of each transistor set, Cn is a total capacitance of each transistor set, Ratio n is a ratio of switches in each transistor set being turned on, and Poutn is an output power of the $n^{\text{th}}$ transistor set.

A loss of a switched capacitor in each transistor set is calculated as follows:

$$P_{\text{sc1}} = f * \text{V}_1^2 * (Ratio\_1 - Ratio\_1^2) * Ctotal$$

$$P_{\text{sc2}} = f * \text{V}_2^2 * \left(Ratio_2 - Ratio_2{}^2\right) * Ctotal \\ -f * \text{V}_1^2 * (Ratio_2) * Ctotal$$

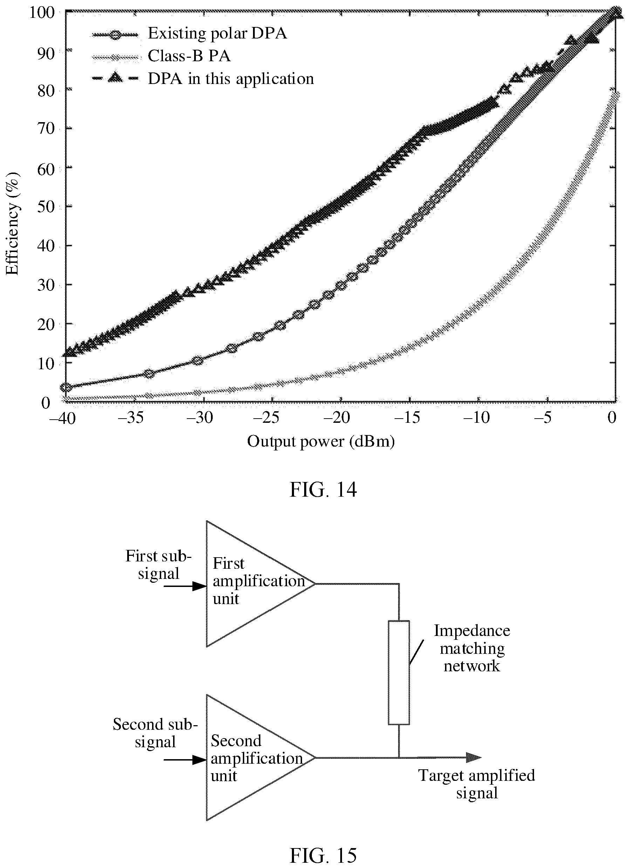

It should be noted that, when a loss Psc2 of a switched capacitor of a second transistor set is determined, it is first assumed that all remaining transistor sets Groups are grounded, and a loss of the second transistor set Group2 when operating independently is calculated. However, because a first transistor set Group 1 operates normally in this case, a relative voltage difference between the second transistor set Group2 and the first transistor set Group 1 is V2-V1. Therefore, a loss Psc1 of a switched capacitor of a first transistor set needs to be subtracted. The transistor sets Group3 to Group6 are deduced by analogy, and details are not described herein again. Efficiency may be calculated based on the output power Pout of the transistor set and the loss Pcs of the switched capacitor of the transistor set. As shown in FIG. 14, compared with efficiencies of the Class-B PA and the Polar DPA, it can be obviously learned that the DPA in this embodiment of this application significantly improves efficiency of the power amplifier.

In this embodiment of this application, the DPA may be further combined with a method such as a load modulation technology and a power supply modulation technology, to further improve efficiency of the power amplifier, thereby reducing power consumption of the DPA.

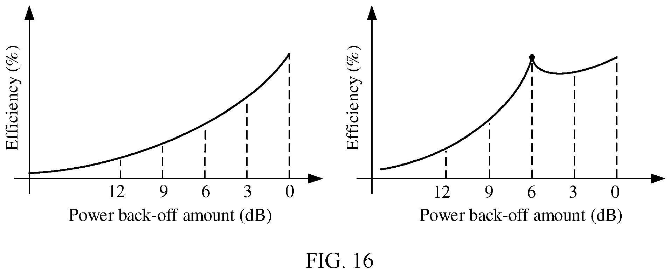

The following uses a Doherty power amplifier in load modulation as an example for description. FIG. 15 is an example of a schematic diagram of a structure of a Doherty power amplifier. The Doherty power amplifier includes a first power amplification unit, a second power amplification unit, and an impedance transformation network. The first power amplification unit is a primary power amplifier, and the second power amplification unit is a secondary power amplifier; or the first power amplification unit is a secondary power amplifier, and the second power amplification unit is a primary power amplifier. As power strength of the input signal varies, an operating region of the Doherty power amplifier may be roughly divided into three stages: a low-power region, a backoff return, and a full-power region. The following describes the three phases in detail with reference to an efficiency curve chart of the Doherty power amplifier in FIG. 16.

(1) A low-power region

In the low-power region, a bias mode of the circuit (peak circuit) of the secondary power amplifier is class C, and input power of the secondary power amplifier is insufficient to drive the secondary power amplifier to work. In this case, the peak path is open-circuited. In addition, the impedance of the circuit (main circuit) of the primary power amplifier remains unchanged. As input power of the power amplifier increases, the primary power amplifier enters a saturation state, and the voltage reaches a full swing, to implement a first high power point during operation of the Doherty power amplifier. For example, as shown in FIG. 16, a power back-off point corresponding to the first high power point of the power amplifier is 6 dB, that is, the input power of the power amplifier is 6 dB less than that when both the primary power amplifier and the secondary power amplifier in the power amplifier have full power.

(2) A power back-off region

As the input power of the power amplifier gradually increases, a peak circuit is opened. In this case, the impedance of a main circuit gradually decreases, but the voltage of the main circuit is always full swing and remains in a saturation state. At the same time, the impedance of the peak circuit also gradually decreases, and the voltage gradually increases, but does not reach the saturation state. Therefore, operating efficiency of the Doherty power amplifier slightly decreases.

(3) A full-power region

As the input power of the power amplifier is further increased, both the main circuit and the peak circuit reach the saturation state, and both the voltages reach a full swing. In this case, the Doherty power amplifier implements a second high power point during operation. For example, as shown in FIG. 16, a power back-off point of the power amplifier corresponding to a second high-power point is 0 dB. In this case, the power amplifier is in a maximum output power state in the entire system.

It can be seen that, when the power amplifier operates far away from the full-power region and enters the power back-off region (a power back-off amount 0 dB to 6 dB shown in FIG. 16), a relatively high efficiency of the power amplifier may still be ensured, and power consumption is relatively low. Therefore, the digital power amplifier in this application may further improve efficiency of the DPA power amplifier with reference to a Doherty principle.

In some embodiments, the DPA in this embodiment of this application may include a first power amplification unit, a second power amplification unit, and a combination unit. The N transistor sets are located in the first power amplification unit and/or the second power amplification unit.

The first power amplification unit is configured to amplify a first sub-signal of the to-be-amplified signal to obtain a first amplified sub-signal, and send the first amplified sub-signal to the combination unit. The second power amplification unit is configured to amplify a second sub-signal of the to-be-amplified signal to obtain a second amplified sub-signal, and send the second amplified sub-signal to the combination unit. The combination unit is configured to combine the first amplified sub-signal and the second amplified sub-signal to obtain a target amplified signal corresponding to the to-be-amplified signal.

In this case, a signal from the baseband processing unit may be divided into a first sub-signal and a second sub-signal, and the first sub-signal and the second sub-signal are divided into two channels, and are input to the first power amplification unit and the second power amplification unit. Therefore, the first sub-signal may be amplified by the first power amplification unit, and the second sub-signal may be amplified by the second power amplification unit. The first amplified sub-signal amplified by the first power amplification unit and the second amplified sub-signal amplified by the second power amplification unit may be combined through the combination unit, so as to obtain the target amplified signal corresponding to the to-be-amplified signal.

The first power amplification unit and/or the second power amplification unit are/is combined with a power amplification manner of the N transistor sets in the DPA in this application, so that a quantity of transistors required in the first power amplification unit and/or the second power amplification unit may be reduced, and power amplification efficiency and a power amplification effect may be improved.

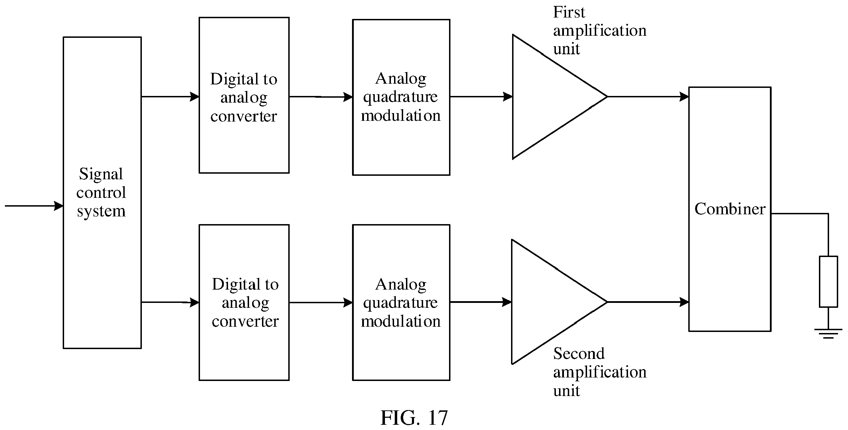

For another example, an outphasing load modulation technology in the DPA may also be combined to further improve overall efficiency of the DPA. FIG. 17 is a schematic diagram of a structure of a radio frequency power amplification system with an outphasing architecture. A signal control system (Signal Control System, SCS) splits an input baseband digital signal into two digital signals for output. For each digital signal output by the SCS, the digital to analog converter converts the digital signal into the analog signal, and then an analog quadrature modulation (Analog Quadrature Modulation, AQM) module performs quadrature modulation on the analog signal, to output the radio frequency signal to the first power amplification unit and the second power amplification unit for power amplification. The two radio frequency signals are combined at the combiner. For a specific setting manner of the first power amplification unit and the second power amplification unit, reference may be made to the setting manner of the first power amplification unit and the second power amplification unit in FIG. 17, and details are not described herein again.

To further improve efficiency of the DPA, in this embodiment of this application, another load modulation technology and power supply modulation technology may be further combined, for example, load modulation based on a transformer-based power synthesis network, or power supply modulation based on a Class-G dual power supply, to improve efficiency of a deep backoff region.

It should be noted that a connection in this application describes a connection relationship between two objects, and may represent two connection relationships. For example, a connection between A and B may represent two cases: A is directly connected to B, and A is connected to B through C. In addition, it should be understood that, in the description of this application, terms "first" and "second" are only used to distinguish the purpose of the description, but cannot be understood as indication or implication of relative importance, and cannot be understood as an indication or implication of a sequence. In addition, the system structure and the service scenario provided in embodiments of this application are mainly intended to explain some possible implementations of the technical solutions of this application, and should not be construed as a unique limitation on the technical solutions of this application. A person of ordinary skill in the art may know that, with evolution of a system and emergence of an updated service scenario, the technical solutions provided in this application are also applicable to a same or similar technical problem.

It is clear that a person skilled in the art may make various modifications and variations to this application without departing from the protection scope of this application. In this case, if the modifications and variations of this application fall within the scope of the claims of this application and equivalent technologies thereof, this application also intends to include the modifications and variations.

**Claims**

1. A digital power amplifier DPA, comprising:

    a decoder and N transistor sets, wherein the decoder comprises an input end and N groups of output ends, the input end of the decoder is connected to a baseband processing unit, the N groups of output ends of the decoder are respectively connected to the N transistor sets, and the N transistor sets operate within at least two different operating voltage ranges;
    the decoder is configured to receive K quantization levels corresponding to a to-be-amplified signal from the baseband processing unit, and send a target quantization level that is within a same operating voltage range and that is of the K quantization levels to a transistor set that operates within the operating voltage range, wherein N is a positive integer greater than 1, and K is a positive integer; and
    the N transistor sets are configured to respectively amplify target quantization levels received by the N transistor sets.

2. The DPA according to claim 1, wherein at least two transistor sets in the N transistor sets operate within a first operating voltage range, the first operating voltage range comprises at least two voltage sub-ranges in which voltage values do not overlap, and the at least two voltage sub-ranges are in a one-to-one correspondence with the at least two transistor sets;

    the decoder is configured to send a target quantization level that is within a same voltage sub-range and that is of the K quantization levels to a transistor set corresponding to the voltage sub-range; and
    the transistor set corresponding to the voltage sub-range is configured to amplify a received quantization level within the voltage sub-range.

3. The DPA according to any one of claims 1 to 2, wherein two transistor sets in the N transistor sets correspond to a same operating voltage range, and the two transistor sets correspond to different quantities of quantization bits; and the decoder is further configured to: determine, from the K quantization levels, a target quantization level within the operating voltage range corresponding to the two transistor sets; select, from the two transistor sets, a target transistor set whose quantity of quantization bits is the same as a quantity of quantization bits corresponding to the target quantization level; and send the target quantization level corresponding to the operating voltage range to the target transistor set.

4. The DPA according to any one of claims 1 to 3, wherein for any operating voltage range in the N operating voltage ranges,

a magnitude of the operating voltage range or a quantity of quantization bits corresponding to a transistor set that operates within the operating voltage range is related to a probability that a voltage value of an envelope signal of an analog signal of the to-be-amplified signal appears within the operating voltage range; or
a magnitude of the operating voltage range or a quantity of quantization bits of a transistor set that operates within the operating voltage range is related to a probability that power spectral density of an envelope signal of an analog signal of the to-be-amplified signal appears within the operating voltage range.

5. The DPA according to any one of claims 1 to 4, wherein the transistor set comprises at least one transistor, and the at least one transistor uses a same operating voltage.

6. The DPA according to any one of claims 1 to 5, wherein the transistor set further comprises:

a first switched capacitor, wherein the first switched capacitor is connected to all transistors in the transistor set; or
each second switched capacitor connected to each transistor in the transistor set, wherein
the first switched capacitor or each second switched capacitor is configured to receive a quantization level corresponding to the transistor set, and transmit the quantization level to a connected transistor; and
the transistor is configured to amplify the quantization level sent by the switched capacitor.

7. The DPA according to any one of claims 1 to 6, wherein each of the N transistor sets corresponds to one or more of K quantization bits; and
the decoder is configured to: determine a target quantization bit of the target quantization level in the K quantization bits, and send the target quantization level to a transistor set corresponding to the target quantization bit.

8. The DPA according to any one of claims 1 to 7, wherein the DPA comprises a first power amplification unit, a second power amplification unit, and a combination unit, wherein the first power amplification unit is a primary power amplifier, and the second power amplification unit is a secondary power amplifier; or the first power amplification unit is a secondary power amplifier, and the second power amplification unit is a primary power amplifier; and the N transistor sets are located in the first power amplification unit and/or the second power amplification unit, wherein

the first power amplification unit is configured to amplify a first sub-signal of the to-be-amplified signal to obtain a first amplified sub-signal, and send the first amplified sub-signal to the combination unit;
the second power amplification unit is configured to amplify a second sub-signal of the to-be-amplified signal to obtain a second amplified sub-signal, and send the second amplified sub-signal to the combination unit; and
the combination unit is configured to combine the first amplified sub-signal and the second amplified sub-signal, to obtain a target amplified signal corresponding to the to-be-amplified signal.

9. The DPA according to any one of claims 1 to 8, wherein the DPA further comprises an impedance matching network, and the impedance matching network is configured to match impedance of the N transistor sets.

10. A communication system, comprising:

a baseband processing unit;
at least one digital power amplifier DPA according to any one of claims 1 to 9 that is connected to the baseband processing unit; and
an antenna connected to the at least one DPA.

FIG. 1

Radio frequency
front end

RF receive path
(Receiver)

Mixer

Filter

Digital to
analog
conversion

Low noise
amplifier

Antenna switch

Baseband processing unit

RF transmit path
(transmitter)

Driver
amplifier

Filter

Digital to
analog
conversion

Power
amplifier

Mixer

Intermediate
frequency
amplifier

FIG. 2

Power amplifier
(Including a transistor array)

Decoder

Phase-modulated
signal

Mixer

Variable gain
amplifier

Modulation

Amplitude
signal

Phase
signal

Coordinate rotation
digital computer unit

Filter 1

Filter 2

Digital to analog
converter

Baseband processing unit

FIG. 3

FIG. 4

EP 4 311 106 A1

FIG. 5

FIG. 6

U2

U0

U1

FIG. 7a

U2

Operating voltage range 6

Operating voltage range 5

Operating voltage range 4

Operating voltage range 3

Operating voltage range 2

Operating voltage range 1

U1

FIG. 7b

FIG. 8

FIG. 9

Voltage range

U1                                    U2

Voltage range 3

Transistor set          Transistor set
3-1                         3-2

FIG. 10a

U1              V2              V1              V3              U2

First operating voltage range
First transistor set

Second operating voltage range
Second transistor set

Third operating voltage range
Third transistor set

FIG. 10b

U1        V2    V1              V4    V3              U2

2 bits   2 bits    2 bits      2 bits       2 bits

First operating
voltage range

Second operating
voltage range

Third operating
voltage range

FIG. 10c

Operating voltage

Output the quantization level

Transistor 3

Input a quantization level

Operating voltage

Output the quantization level

Operating voltage

Input a quantization level

Transistor 2

Operating voltage

Input a quantization level

Output the quantization level

Operating voltage

Input a quantization level

Transistor 1

Operating voltage

Output the quantization level

Input a quantization level

FIG. 11

FIG. 12

FIG. 13

FIG. 14

FIG. 15

FIG. 16

FIG. 17

EP 4 311 106 A1

## INTERNATIONAL SEARCH REPORT

| International application No. |
| --- |
| **PCT/CN2021/135499** |

| A. | CLASSIFICATION OF SUBJECT MATTER |
| --- | --- |

H03F 1/02(2006.01)i

According to International Patent Classification (IPC) or to both national classification and IPC

| B. | FIELDS SEARCHED |
| --- | --- |

Minimum documentation searched (classification system followed by classification symbols)

H03F

Documentation searched other than minimum documentation to the extent that such documents are included in the fields searched

Electronic data base consulted during the international search (name of data base and, where practicable, search terms used)

CNABS; CNTXT; VEN; USTXT; EPTXT; WOTXT; CNKI: 功率放大, 功放, 数字功率放大器, 解码, 电压, 电平, 晶体管, 基带, power amplifier, digital power amplifier, DPA, decode, voltage, level, transistor, baseband

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| A | CN 112262528 A (ARGO SEMICONDUCTORS FS LTD. (HE 359654)) 22 January 2021 (2021-01-22)<br>description, paragraphs 17-34 | 1-10 |
| A | CN 203406835 U (WUHAN SYNTEK CO., LTD.) 22 January 2014 (2014-01-22)<br>description, paragraphs 26-49 | 1-10 |
| A | CN 111865236 A (HUAWEI TECHNOLOGIES CO., LTD.) 30 October 2020 (2020-10-30)<br>entire document | 1-10 |
| A | US 2010188148 A1 (TEXAS INSTRUMENTS INC.) 29 July 2010 (2010-07-29)<br>entire document | 1-10 |
| A | ZOU, Wei et al. "2.49–4.91 GHz Wideband VCO with Optimised 8-shaped Inductor"<br>*ELECTRONICS LETTERS,* Vol. 55, No. 1, 10 January 2019 (2019-01-10),<br>pp. 1-2 | 1-10 |
| A | CHIARA, R. et al. "High Efficiency Power Amplifiers for Modern Mobile Communications: The Load-Modulation Approach"<br>*Electronics,* 13 November 2017 (2017-11-13),<br>sections 2-6 | 1-10 |

| ☐ Further documents are listed in the continuation of Box C. | ☑ See patent family annex. |
| --- | --- |

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **05 February 2022** | **23 February 2022** |

| Name and mailing address of the ISA/CN | Authorized officer |
| --- | --- |
| **China National Intellectual Property Administration (ISA/CN)**<br>**No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

INTERNATIONAL SEARCH REPORT
Information on patent family members

International application No.

**PCT/CN2021/135499**

| Patent document cited in search report | | | Publication date (day/month/year) | Patent family member(s) | | | Publication date (day/month/year) |
|---|---|---|---|---|---|---|---|
| CN | 112262528 | A | 22 January 2021 | WO | 2020025070 | A1 | 06 February 2020 |
| | | | | IN202117003670 | | A | 26 March 2021 |
| | | | | US | 2021273618 | A1 | 02 September 2021 |
| CN | 203406835 | U | 22 January 2014 | None | | | |
| CN | 111865236 | A | 30 October 2020 | WO | 2020215732 | A1 | 29 October 2020 |
| US | 2010188148 | A1 | 29 July 2010 | None | | | |

Form PCT/ISA/210 (patent family annex) (January 2015)

**REFERENCES CITED IN THE DESCRIPTION**

**Patent documents cited in the description**

- CN 202110389641